# EUROPÄISCHE PATENTSCHRIFT

(11) **EP 0 353 518 B1**
(45) Veröffentlichungstag und Bekanntmachung des Hinweises auf die Patenterteilung: **25.05.1994**
(21) Anmeldenummer: 89112833.2
(22) Anmeldetag: 13.07.1989
(51) Int. Cl.: H01L 21/306, C30B 33/00, C30B 29/06

(54) **Verfahren zur Konservierung der Oberfläche von Siliciumscheiben**
Process for preserving the surface of silicon wafers
Procédé de conservation de la surface de plaquettes de silicium

(30) Priorität: 13.07.1988 DE 3823765
(43) Veröffentlichungstag der Anmeldung: 07.02.1990
(73) Patentinhaber: Wacker-Chemitronic Gesellschaft für Elektronik-Grundstoffe mbH, D-84489 Burghausen (DE)
(72) Erfinder: Prigge, Helene, Dr., Dipl.-Chem., D-8044 Unterschleissheim (DE); Schnegg, Anton, Dr., Dipl.-Chem., D-8263 Burghausen (DE); Brehm, Gerhard, Dr., Dipl.-Ing., D-8261 Emmerting (DE)

(56) Entgegenhaltungen:
- EP-A- 0 204 189
- EP-A- 0 222 400
- EP-A- 0 311 994
- FR-A- 2 200 772
- US-A- 2 900 702
- EXTENDED ABSTRACTS, Band 87-1, Nr. 1, Frühling 1987, Seite 381-382, Zusammenfassung Nr. 262, Philadelphia, PA, US; I. LAMPERT: "Influence of the cleaning method on the chemical behavior of hydrophilic silicon surfaces"

## Beschreibung

Die Erfindung betrifft ein Verfahren zur Konservierung der Oberfläche von Siliciumscheiben durch Aufbringen von Schutzschichten.

Es ist bekannt, daß beim Polieren von Siliciumscheiben die beim Poliervorgang erzeugte einwandfreie Oberfläche bereits unmittelbar nach dessen Beendigung einer Vielzahl von Einflüssen ausgesetzt ist, die eine Verschlechterung der Oberflächenqualität bewirken können. Beispielhaft seien hier die Einwirkung von Poliermittelresten, Waschwasser, Waschlösungen oder die umgebende Atmosphäre genannt. Diese Effekte kommen insbesondere bei der Zweiseitenpolitur zum Tragen, bei der die Scheibenentnahme nach Beendigung des Poliervorganges verhältnismäßig zeitaufwendig ist.

Üblicherweise werden daher im Anschluß an den Poliervorgang die Siliciumscheiben nach ihrer Entnahme aus dem Poliergerät einer oxidierenden Reinigung, beispielsweise durch Eintauchen in eine Ammoniak/Wasserstoffperoxidlösung, unterworfen, um derartige Beeinträchtigungen der Oberflächenqualität zu verhindern oder zu beseitigen. Die dabei gebildete Oxidschicht kann jedoch ihrerseits wieder Alterungseffekten unterworfen sein und beispielsweise bei nachgeschalteten thermischen Oxidationsschritten die Bildung der als "haze" bezeichneten schleierartigen Eintrübungen auf der polierten Oberfläche verursachen, die z.B. im gebündelten Licht als diffuse Reflexionen auf der Scheibenoberfläche sichtbar werden.

In der DE-A-35 40 469 bzw. der entsprechenden US-A-4 724 171 wurde deshalb vorgeschlagen, die Siliciumscheiben im Anschluß an den Poliervorgang zunächst einer oxidierenden Reinigung zu unterziehen und anschließend die Oberfläche mit Hexamethyldisilazan zu behandeln. Die dadurch erzielte Schutzwirkung beruht darauf, daß die auf der oxidierten Siliciumoberfläche vorhandenen OH-Gruppen unter Trimethylsilylierung reagieren und sich somit auf der Oberfläche ein dünner Schutzfilm ausbildet, durch den schädliche Einwirkungen von der eigentlichen polierten Scheibe ferngehalten werden. Bei diesem Verfahren ist jedoch nicht völlig auszuschließen, daß im Zeitraum zwischen dem Abschluß des Poliervorganges und dem Beginn der oxidierenden Reinigung auf der Scheibenoberfläche entstandene Störungen wie etwa Anätzungen und dergleichen nur unvollständig entfernt und unter dem Schutzfilm weitergeschleppt werden.

Aufgabe der Erfindung war es, ein Verfahren anzugeben, das vielseitig einsetzbar ist und eine wirksame Konservierung der Scheibenoberfläche ermöglicht, und zwar sowohl in der Phase zwischen dem Abschluß des Poliervorganges und dem Beginn nachgeschalteter Reinigungsschritte, als auch gegebenenfalls erst im Anschluß an eine Reinigungsbehandlung der Scheiben.

Gelöst wird die Aufgabe durch ein Verfahren, welches dadurch gekennzeichnet ist, daß in einem ersten Schritt eine hydrophobe Scheibenoberfläche erzeugt und in einem daran angeschlossenen Schritt die Oberfläche mit einem aus der Gruppe der aliphatischen Alkohole, Organosilane oder insbesondere Silanole ausgewählten Reagens behandelt wird.

Kennzeichnend für die Oberfläche von hydrophoben Siliciumscheiben ist das Vorliegen von hauptsächlich Si-H und SiCHₓ-Gruppen, während Sauerstoff im wesentlichen nicht vorhanden ist. Diese Sachverhalte sind in einem Artikel von M. Grundner und H. Jacob, Investigations on Hydrophilic and Hydrophobic Silicon (100) Wafer Surfaces by X-Ray Photoelectron and High-Resolution Electron Energy Loss-Spectroscopy, Appl. Phys. A 39, p. 73ff.(1986), näher erläutert.

Für die Erzeugung solcher im wesentlichen oxidfreier, Silicium-Wasserstoffbindungen aufweisender Scheibenoberflächen kommt eine Methode in Frage. Dies ist bei auf ihrer Oberfläche eine Oxidschicht aufweisenden Siliciumscheiben eine Behandlung mit wässriger oder gasförmiger Flußsäure, durch welche die oxidischen Phasen von der Oberfläche abgelöst werden, wobei entstehende freie Bindungen am Silicium zumindest teilweise mit Wasserstoff abgesättigt werden.

Die Behandlung kann beispielsweise dadurch erfolgen, daß die Scheiben in ein wässrige Flußsäure enthaltendes Bad eingetaucht werden und bis zur weitgehenden oder vollständigen Ablösung der Oxidschicht dort belassen werden. Gleichfalls möglich ist es z.B., die Scheibenoberfläche mit Flußsäure zu besprühen oder zu spülen. Zweckmäßig wird anschließend die überschüssige Flußsäure durch Abwaschen mit deionisiertem Wasser entfernt. Geeignete Verfahrensabläufe und -parameter sind beispielsweise in dem o.g. Artikel angesprochen und auch von den üblichen Reinigungsprozessen her bekannt, bei denen eine Abfolge verschiedener naßchemischer Behandlungsschritte, darunter meist auch eine oder mehrere Flußsäurebehandlungen, auf die Oberfläche von polierten Siliciumscheiben einwirkt. Als Beispiel sei der von W. Kern und D.

Puotinen in RCA Review, June 1970, S. 187-206 beschriebene Prozeß genannt. Diese bekannten Methoden und Bedingungen für die Behandlung mit Flußsäure, beispielsweise was Konzentrationen, Temperaturen, Einwirkungsart und -dauer betrifft, können analog auch bei dem erfindungsgemäßen Verfahren eingesetzt werden.

Für den zweiten Verfahrensschritt werden zur Behandlung der Scheibenoberfläche vorzugsweise wässrige Lösungen eingesetzt, die als Reagens aliphatische Alkohole, Organosilane oder insbesondere Silanole enthalten, wobei sowohl Gemische verschiedener als auch bevorzugt einzelne Verbindungen für sich in Frage kommen. Dabei hat es sich besonders bewährt, jeweils solche Reagenzien auszuwählen, deren Löslichkeit in Wasser einerseits gewährleistet, daß am Einsatzort, d.h. auf der Scheibenoberfläche, ein ausrechende Menge des Reagens zur Verfügung gestellt wird, dieses aber auch in genügendem Maße von der wässrigen Phase freigegeben wird, um mit der Oberfläche wechselwirken und von ihr gebunden werden zu können. Dabei wurde gefunden, daß diesen Anforderungen am besten von solchen Reagenzien entsprochen wird, die mit Wasser bis zu einem Anteil von ca. 15 Vol%, vorzugsweise bis zu etwa 8 Vol%, jeweils bezogen auf die Gesamtmenge, mischbar sind.

Es ist jedoch neben dem Einsatz wässriger Lösungen in manchen Fällen auch nicht ausgeschlossen, die Reagenzien in gasförmigem Zustand auf die Scheibenoberfläche einwirken zu lassen, beispielsweise in Begasungskammern und günstig im Anschluß an epitaktische oder Plasmaätzprozesse.

Aus Gründen der Arbeitssicherheit werden vorteilhaft solche Reagenzien ausgewählt, die einen möglichst geringen Dampfdruck aufweisen, um das Risiko der Ausbildung zündfähiger Gemische, oder gesundheitlicher Gefährdung des Bedienungspersonals durch Einatmen schädlicher Dämpfe niedrig zu halten.

Zweckmäßig werden Lösungen eingesetzt, deren Anteil an Reagens auf 0.1 bis 10 Vol%, bevorzugt 0.2 bis 5 Vol% eingestellt ist. Grundsätzlich können anstelle homogener Phasen auch zweiphasige Gemische eingesetzt werden, bei denen eine wässrige und eine organische Phase nebeneinander vorliegen, z.B. als Emulsion oder Dispersion. Die Anwendungstemperaturen liegen in der Regel zwischen 10 und 80°C, vorzugsweise 20 und 50°C.

Geeignete Reagentien aus den Gruppe der aliphatischen Alkohole sind z.B. geradkettige einwertige Alkanole wie Ethanol, Propanol oder Butanol. Auch zweiwertige Alkohole wie etwa Ethylenglykol oder dreiwertige Alkohole wie etwa Glycerin können eingesetzt werden. Ebenso lassen sich höhere Organosilane der Formel R₃SiOH, R₂Si(OR′)₂, HO(SiR₂O)ₙ mit R = CH₃, C₂H₅, C₃H₇, R′= CH₃, C₂H₅ und n = 10 - 15 verwenden. Bevorzugt werden Trialkylsilanole eingesetzt, die als Alkylgruppen Ethyl- und/oder Propylgruppen, mit besonderem Vorteil aber auch oder nur Methylgruppen enthalten. Die besten Ergebnisse werden mit Trimethylsilanol als Reagens erzielt, wobei sich der Konzentrationsbereich von ca. 0.2 bis 5 Vol% als besonders günstig erwiesen hat. Der Vorteil der Trialkylsilanole, insbesondere des Trimethylsilanols liegt darin, daß bei ihrem Einsatz besonders niedrige Ätzfleckenanteile festzustellen sind und daß sie wegen der Geruchsfreiheit und niedrigen Flüchtigkeit auch äußerst problemlos handzuhaben ist.

Die Scheiben, die in dem ersten Schritt mittels Flußsäure behandelt wurden, lassen sich zweckmäßig durch Eintauchen in ein die jeweils ausgewählte Lösung enthaltendes, ggf. auch temperiertes Bad an ihrer Oberfläche konservieren. Andere Möglichkeiten bestehen beispielsweise darin, die Lösung durch Sprühen oder Spülen auf die Scheibenoberflächen aufzubringen. Grundsätzlich gelten für diese geeigneten Verfahrensweisen die bereits vorher im Zusammenhang mit der Flußsäurebehandlung gemachten Aussagen.

Für den am ersten Schritt direkt angeschlossenen zweiten Schritt ist in den meisten Fällen erfahrungsgemäß eine Behandlungsdauer von wenigen, vorzugsweise 0.3 bis 10 Minuten, ausreichend. Die danach erhaltenen Scheiben besitzen eine hydrophobe Oberfläche, d.h. sie werden von Wasser nicht benetzt, können dadurch von ätzenden wässrigen Phasen nicht mehr angegriffen werden und sind gleichzeitig auch gegenüber Einwirkungen der Umgebungsatmosphäre geschützt.

Die auf der Scheibenoberfläche gebildete, konservierende Schutzschicht kann von anscließenden Weiterverarbeitungsschritten durch eine oxidierende Behandlung beseitigt und in eine oxidische Schicht umgewandelt werden. Eine solche Oxidation kann beispielsweise bei 800 bis 1200°C in Sauerstoffatmosphäre durchgeführt werden. Grundsätzlich ist auch ein elektro- oder naßchemischer Oxidationsschritt, beispielsweise mit den aus Reinigungsprozessen bekannten Agentien wie Ammoniak/Wasserstoffperoxidlösung möglich. Oxidische Schichten werden ohnehin bei den meisten Weiterverarbeitungsprozessen im ersten Verfahrensschritt erzeugt, so daß diese letztendlich durch die Schutzschicht nicht gestört werden.

Das erfindungsgemäße Verfahren wird mit besonderem Vorteil für die Konservierung von polierten Siliciumscheiben in der Zwischenphase zwischen Politur und anschließender Endreinigung eingesetzt; die solchermaßen behandelten Scheiben lassen sich nämlich problemlos und ohne die Gefahr von Beeinträchtigungen der Oberflächenqualität transportieren und/oder über Monate hinweg lagern. Damit ermöglicht es auch eine größere innerbetriebliche Flexibilität bei der Prozeßabfolge Polieren-Endreinigung. Weitere Anwendungsmöglichkeiten liegen in der Vorbehandlung von für die Epitaxie vorgesehenen Siliciumscheiben, wie auch in der Konservierung von in hydrophobem Zustand vorliegenden Scheibenoberflächen.

Nachstehend wird die Erfindung an Hand von einem Ausführungsbeispeil näher erläutert:

### Beispiel :

50 einseitig polierte Siliciumscheiben (Durchmesser ca. 100 mm, Dicke etwa 525 µm, (100)-Orientierung) wurden über mehrere Wochen hinweg in einer üblichen Halbleiterverpackung gelagert und hatten sich dabei mit einer dünnen Oberflächenoxidschicht ("native oxide") überzogen. Diese Scheiben wurden nun einer Reinigung unterzogen, indem sie zunächst in einer handelsüblichen Sprühreinigungskammer ca. 5 min lang mit einer etwa 2 gew%igen wässrigen Flußsäurelösung besprüht wurden, um das Oxid zu entfernen und eine hydrophobe Scheibenoberfläche zu schaffen. Daran schloß sich eine ca. einminütige Spülung mit deionisiertem Wasser an.

25 Scheiben wurden nun in einem zweiten Behandlungsschritt für etwa 3 min mit einer ca. 1 Vol% Trimethylsilanol enthaltenden wässrigen Lösung und abschließend wieder etwa 1 min lang mit deionisiertem Wasser besprüht.

Die anderen 25 Scheiben wurden im zweiten Schritt weiter für ca. 4 min nur mit deionisiertem Wasser besprüht.

Beide Scheibengruppen wurden danach getrocknet und eine Woche lang an Luft bei 45% Luftfeuchtigkeit gelagert. Während auf den nur mit Wasser behandelten Scheiben bereits nach 3 Tagen die Bildung von kleinen Flecken (Durchmesser ca. 2 µm) einsetzte, waren die mit der Trimethylsilanol-Lösung behandelten Scheiben auch nach einer Woche noch völlig fleckenfrei.

## Patentansprüche

1. Verfahren zur Konservierung der Oberfläche von Siliciumscheiben durch Aufbringen einer Schutzschicht, dadurch gekennzeichnet, daß in einem ersten Schritt durch die Behandlung mit Flußsäure eine hydrophobe Scheibenoberfläche erzeugt und in einem direkt daran angeschlossenen, zweiten Schritt die Oberfläche mit Ethanol, Propanol oder Butanol oder mit einem aus der Gruppe der zweiwertigen oder dreiwertigen Alkohole oder der Gruppe der Organosilane, insbesondere Silanole, ausgewählten Reagens behandelt wird.

2. Verfahren nach Anspruch 1, dadurch gekennzeichnet, daß das Reagens in wässriger Losung eingesetzt wird.

3. Verfahren nach Anspruch 1 oder 2, dadurch gekennzeichnet, daß der Anteil des Reagens an der Lösung auf 0.1 bis 10 Vol%, bezogen auf die Gesamtmenge, eingestellt wird.

4. Verfahren nach den Ansprüchen 2 oder 3, dadurch gekennzeichnet, daß ein Reagens ausgewählt wird, welches mit Wasser bis zu einem Anteil von 15 Vol%, bezogen auf die Gesamtmenge, mischbar ist.

5. Verfahren nach einem oder mehreren der Ansprüche 1 bis 4, dadurch gekennzeichnet, daß als Reagens ein Trialkylsilanol ausgewählt wird.

6. Verfahren nach einem oder mehreren der Ansprüche 1 bis 5, dadurch gekennzeichnet, daß als Reagens Trimethylsilanol ausgewählt wird.

## Claims

1. Process for preserving the surface of silicon wafers by depositing a protective layer, characterized in that a hydrophobic wafer surface is produced by treating with hydrofluoric acid in a first step and the surface is treated with ethanol, propanol or butanol, or with a reagent selected from the group comprising the dihydric or trihydric alcohols or the group comprising the organo silanes, in particular silanols, in a second step directly subsequent thereto.

2. Process according to Claim 1, characterized in that the reagent is used in aqueous solution.

3. Process according to either of Claims 1 or 2, characterized in that the proportion of the reagent in the solution is adjusted to 0.1 to 10% by volume, based on the total quantity.

4. Process according to either of Claims 2 or 3, characterized in that a reagent is selected which is miscible with water up to a proportion of 15% by volume, based on the total quantity.

5. Process according to one or more of Claims 1 to 4, characterized in that a trialkylsilanol is selected as reagent.

6. Process according to one or more of Claims 1 to 5, characterized in that trimethylsilanol is selected as reagent.

## Revendications

1. Procédé de préservation de la surface de plaquettes de silicium par le dépôt d'une couche protectrice, procédé caractérisé en ce que dans une première opération on forme une surface hydrophobe par traitement avec de l'acide fluorhydrique, et dans une seconde opération qui suit directement la première on traite la surface avec de l'éthanol, du propanol ou du butanol ou avec un réactif pris parmi des dialcools et des trialcools ou parmi des organosilanes, en particulier des silanols.

2. Procédé selon la revendication 1, caractérisé en ce que le réactif est employé en solution aqueuse.

3. Procédé selon la revendication 1 ou 2, caractérisé en ce que la teneur de la solution en réactif est de 0,1 à 10% du volume total.

4. Procédé selon la revendication 2 ou 3, caractérisé en ce que l'on opère avec un réactif miscible à l'eau jusqu'à une proportion de 15% du volume total.

5. Procédé selon une ou plusieurs des revendications 1 à 4, caractérisé en ce que le réactif est un trialkylsilanol.

6. Procédé selon une ou plusieurs des revendications 1 à 5, caractérisé en ce que le réactif est du triméthylsilanol.
